# EUROPEAN PATENT APPLICATION

(11) **EP 1 136 586 A1**
(43) Date of publication of application: **26.09.2001**
(21) Application number: 01105413.7
(22) Date of filing: 12.03.2001
(51) Int. Cl.: C23C 14/24, C23C 14/26, C23C 14/56

(54) **Evaporation apparatus, particularly adapted to an evaporation plant for forming thin layers on a substrate**

(30) Priority: 18.03.2000 DE 10013635
(71) Applicant: Aguasolar Advances Technologies SA, 6500 Bellinzona (CH)
(72) Inventor: Regittnig, Gerhard, 82407 Wielenbach (DE)
(74) Representative: Modiano, Guido, Dr.-Ing.

(57) **Abstract**

An evaporation apparatus, particularly for forming thin metallization layers on a substrate, comprising a vacuum chamber (1) provided with an inlet opening or port (4) and an outlet opening or port (5), wherein the vacuum chamber comprises means (9) for transporting at least one substrate (8) from the inlet opening to the outlet opening, at least one evaporation source (11) being provided within the vacuum chamber; the evaporation source is movable inside the vacuum chamber, for directing a jet of vaporized material against the substrate in order to obtain a metallization layer.

## Description

The present invention relates to an evaporation apparatus particularly adapted to an evaporation plant for manufacturing thin layers on a substrate. More particularly, the invention relates to the evaporation source for a horizontal evaporation plant, to be used in manufacturing photovoltaic solar modules.

Even more particularly, the present invention relates to an evaporation apparatus for general use in an evaporation or metallization plant for manufacturing thin layers on different substrates.

As is known, for making photovoltaic modules, and in general for the metallization of substrates, vacuum chambers are generally used, within which the substrate is metallized using an evaporation source.

However, currently used solutions have the drawback of not being able to apply metallization layers of different widths on the substrate, to obtain a uniform structure of layers and to have passages or transitions between layers with definite gradients.

Moreover conventional metallization apparatuses are not able to produce surfaces of all sizes and most important, to metallize the whole surface in a single step or pass.

The aim of the present invention is to eliminate the above-mentioned drawbacks by providing an evaporation apparatus, particularly adapted to manufacture thin layers, which allows the metallization of the whole surface of the substrate to be obtained in a single pass or step.

Within this aim, a particular object of the present invention is to provide a metallization apparatus which allows to apply, on a single substrate, several layers having different widths.

Another object of the present invention is to provide a metallization apparatus which allows a uniform structure of the thin layers deposited on the substrate to be obtained.

Another object of the present invention is to provide a metallization apparatus which allows to obtain passages between one layer and the next with definite gradients.

Still another object of the present invention is to provide a metallization apparatus which allows to metallize substrates of any size, and comprised of a wide range of materials.

Not the least object of the present invention is to provide a metallization apparatus which is highly reliable, relatively easy to manufacture and is also competitive from an economical point of view.

This aim and these and other objects which will become better apparent from the following description are achieved by an evaporation apparatus, particularly for making thin metallization layers on a substrate, comprising: a vacuum chamber provided with an inlet opening and outlet or exit opening, characterized in that said vacuum chamber comprises means for transporting at least one substrate from said inlet opening to said outlet opening, at least one evaporation source being provided within said vacuum chamber, said evaporation source being movable within said vacuum chamber, for directing a jet of vaporized material against said substrate in order to obtain a metallization layer.

Further characteristics and advantages of the invention will become better apparent from the following detailed description of a preferred but not exclusive embodiment of the metallization apparatus according to the invention, given only by way of non-limitative example in the accompanying drawings, in which:
Fig. 1 is a schematic cross-section view of the metallization apparatus according to the invention; and
Fig. 2 is a schematic cross-section view of the structure of an evaporation source used in the apparatus of Fig. 1.

With reference to the figures, the evaporation apparatus according to the invention, generally designated by the reference numeral 100, comprises a vacuum chamber 1 provided with a tube 6 for creating a vacuum inside the chamber. The chamber 1 is also provided, at a side thereof, with an inlet opening 4 and, at the opposite side thereof, with an outlet opening or exit 5, said openings facing a first, pre-heating chamber 2 and a second, cooling chamber 3, respectively.

A substrate 8 is then introduced into the chamber 1 through the opening 4, and moves horizontally through the pre-heating chamber 2 to exit at the outlet 5, through the cooling chamber 3.

The substrate is moved along a number of support and transport rollers 9.

Under the support and transport rollers 9, at least one evaporation source 11 is provided, which can move preferably but not exclusively in a direction opposite that of the substrate 8.

Suitably, a plurality of evaporation sources 11 are preferably present, which are arranged to be movable along a closed circuit path, by being supported and transported along an adapted conveyor belt 15, with a row of evaporation sources 11 always arranged underneath the substrate 8 for the metallization of the substrate itself.

Suitably, a plurality of rows of evaporation sources 11 can be placed side by side, in order to vaporize (metallize) the width of the substrate 8 as well as the whole length thereof with one pass, that is a single movement of the substrate 8 within the vacuum chamber 1.

Above each of the metallization sources reflection means 12 are placed, for directing the jet of evaporation material contained in the evaporation source 11 in the direction of the substrate 8. The position, the size of an outlet opening 16 of the reflection means, as well as the angle formed by the walls of said reflection means can be any according to requirements.

The reflection means 12 can be heated.

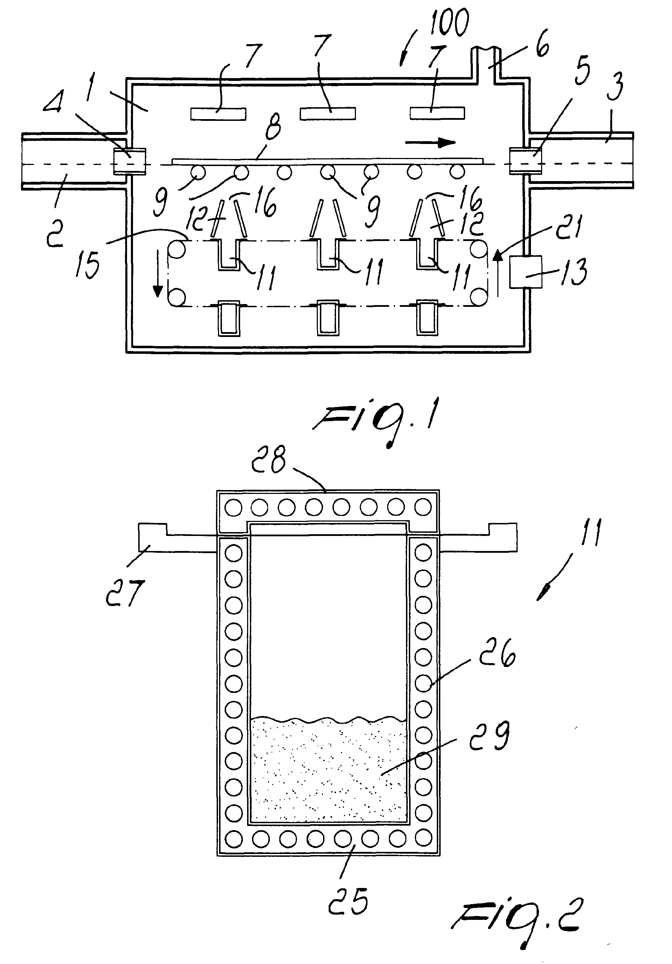

In Figure 1, the arrow indicated by reference number 20 indicates the direction of movement of the substrate 8 inside the vacuum chamber, whereas the arrow indicated by reference number 21 indicates the direction of movement of the evaporation sources 11, which move in a direction opposite to that of the substrate 8.

The evaporation sources 11 can be easily removed from the conveyor belt 15 and the movement of the sources 11 is controlled by a computer and adjusted based on the evaporation material and the layers to be deposited.

Above the substrate 8 at least one heating source 7 and preferably a number of heating sources 7 are placed, which heat by radiation the substrate 8 and are also controlled by a computer.

This guarantees the substrate 8 is heated up and kept at the desired temperature.

The sources 11, which will be described in detail with reference to Fig. 2, are each periodically supplied with the evaporation material, by means of a passage through an opening 13 from a filling station.

With reference to Fig. 2, an evaporation source 11 is shown in detail which is comprised of an evaporation container 25 having, in the thickness of the walls thereof, heating means 26 and a mains socket 27 for obtaining the above-mentioned heating.

Reference number 29 designates the material destined to be vaporized and 28 designates an automatic door which is opened on command on purpose, only for the evaporation process as decided, and most important, when the evaporation source 11 passes by the reflection means 12.

With reference to the above-mentioned figures, operation of the apparatus according to the invention, and therefore the method for the use thereof, are as follows.

The substrate 8, already pre-heated by the passage through the pre-heating chamber 2, is supported and carried by rollers 9 and passed through the opening 4 into the vacuum chamber 1. The substrate 8 is then heated to the desired temperature by means of the heating sources 7 inside the chamber 1. At the same time the evaporation process takes place and the vaporized material from the evaporation sources 11 is directed - through reflection means 12 placed above the evaporation sources 11 - onto the substrate so as to coat the substrate 8 with a layer having the desired thickness.

The position and number of the evaporation sources together with their movement in a direction opposite that of the substrate 8 determine the width of the vaporization (metallization) strips which can be obtained on the substrate 8.

The temperature at which both the substrate 8 and the evaporation material are heated is adjusted based on the evaporation material itself and the emissions of vapor jet from the evaporation sources 11 can be set in various directions by the movable reflection means 12. The thickness of the metallization layer deposited on the substrate is checked through the evaporation process and the layer structure can be adjusted at will both on the evaporation material and the evaporation speed. Accordingly, the passages between one layer and the next can be precisely set.

Therefore, the apparatus and process according to the invention are adapted to produce layers of different materials with definite passages between one layer and the next. This allows, in case determined materials and their compounds are used, such as silicon, copper, gallium, indium, selenium, boron, phosphor, and the like, to produce layers with photovoltaic effect.

Once the evaporation process is over and therefore all the desired metallizations of the substrate have been obtained on the substrate, the substrate is passed through the exit 5 of the vacuum chamber 1, and thence to the cooling chamber 3.

The evaporation apparatus according to the invention therefore makes it possible to apply metallization layers of different widths, according to the number and position of the evaporation sources, and a uniform structure of the layers to be obtained.

Additionally, the passages between one layer and the next can be realized with well defined gradients.

The arrangement of a number of evaporation sources allows to obtain metallizations of any width on a given substrate.

It has thus been observed that the apparatus and the method according to the invention achieve the intended aim and objects in that thanks to the mobility of the evaporation source or sources, the metallization of a substrate can be obtained with the desired width, thickness and quality.

The apparatus thus conceived is susceptible of numerous modifications and variations all of which fall within the scope of the inventive concept; all the details may further be replaced with others technically equivalent.

In practice, the materials employed as well as the shapes and dimensions may be any according to requirements and to the state of the art.

The disclosures in German Patent Application No. 100 13 635.4 from which this application claims priority are incorporated herein by reference.

Where the technical characteristics mentioned in any claim are followed by reference signs, those signs have been included for the sole purpose of increasing the intelligibility of the claims and accordingly those reference signs have no limitative effect on the scope of the elements identified by way of example by said reference signs.

## Claims

1. An evaporation apparatus, particularly for forming thin metallization layers on a substrate, comprising a vacuum chamber provided with an inlet opening and an outlet opening or exit, **characterized in that** said vacuum chamber comprises means for transporting at least one substrate from said inlet opening to said outlet opening, at least one evaporation source being provided within said vacuum chamber, said evaporation source being movable inside said vacuum chamber, for directing a jet of vaporized material against said substrate in order to obtain a metallization layer.

2. The apparatus according to claim 1, **characterized in that** it comprises a number of evaporation sources which are movable inside said vacuum chamber, said evaporation sources being supported and transported by conveyor means placed under said support and transport means of said substrate.

3. The apparatus according to claim 1, **characterized in that** it comprises reflection means adapted to be placed above said at least one evaporation source, for directing said vaporized material jet against said substrate.

4. The apparatus according to claim 1, **characterized in that** said evaporation sources are movable in a direction opposite to that of said substrate.

5. The apparatus according to claim 3, **characterized in that** said reflection means can be heated and can be oriented as to the inclination thereof, in order to direct said vaporized material jet in a selected area of said substrate, the opening of said reflection means being adjustable.

6. The apparatus according to claim 1, **characterized in that** it comprises at least one heating source placed above said substrate moving inside the vacuum chamber.

7. The apparatus according to claim 1, **characterized in that** said evaporation sources can be removed from said transport means.

8. The apparatus according to claim 8, **characterized in that** said vacuum chamber comprises an opening for the passage of said evaporation sources to a station for filling said evaporation sources with material to be vaporized.

9. The apparatus according to claim 1, **characterized in that** said inlet opening of said vacuum chamber faces a pre-heating chamber through which said substrate is passed beforehand.

10. The apparatus according to claim 1, **characterized in that** said outlet opening faces a cooling chamber.

11. The apparatus according to claim 1, **characterized in that** said evaporation sources each comprise an evaporation container for holding said evaporation material, said container being provided with heating means for heating said evaporation material.

12. The apparatus according to claim 11, **characterized in that** said evaporation container is provided with a cover which can be automatically opened for letting out said vaporized evaporation material.

13. An evaporation process for coating a substrate with one or more thin metallization layers, **characterized in that** it comprises the steps of:
passing the substrate to be coated into a vacuum chamber;
moving at least one metallization source for directing vaporized material jet on said substrate, for realizing a coating layer on said substrate;
said evaporation layer being directed to determined areas of said substrate.

14. The process according to claim 13, **characterized in that** it comprises a step of pre-heating said substrate before said substrate enters said vacuum chamber.

15. The process according to claim 13, **characterized in that** it comprises a step of heating said substrate when said substrate is moving into said vacuum chamber.

16. The process according to claim 13, **characterized in that** it comprises a step of heating said evaporation source for generating said vaporized material jet meant for being directed against said substrate, said vaporized material jet being directed by reflection means.

17. The process according to claim 13, **characterized in that** the movement of said at least one metallization source takes place in a direction opposite to that of the substrate.

18. The process according to claim 13, **characterized in that** it comprises a cooling step of said substrate exiting said vacuum chamber.
